# EUROPEAN PATENT APPLICATION

(11) **EP 3 181 734 A1**
(43) Date of publication of application: **21.06.2017**
(21) Application number: 15307021.4
(22) Date of filing: 16.12.2015
(51) Int. Cl.: C30B 13/00, C30B 29/06, C01B 33/037

(54) **MANUFACTURING METHOD OF A SILICON SINGLE CRYSTAL AND SILICON WAFER PRODUCTION FACILITY**

(71) Applicant: TOTAL MARKETING SERVICES, 92800 Puteaux (FR)
(72) Inventor: VERSTRAETEN, David, 78430 LOUVECIENNES (FR)
(74) Representative: Croonenbroek, Thomas Jakob

(57) **Abstract**

The invention relates to a manufacturing method for a silicon single crystal comprising the steps of:
- providing (100) a silicon raw material containing Si-kerf,
- segregating and shaping (102) the silicon raw material as raw material ingot for a floating zone melting method,
- manufacturing (104) a silicon single crystal by a floating zone melting method in using the raw material ingot.

## Description

### FIELD OF THE INVENTION

The invention relates to a manufacturing method for a silicon single crystal and a silicon wafer production facility.

### BACKGROUND AND PRIOR ART

Semiconductor industries rely on manufacturing of high quality silicon wafers at optimized cost.

During manufacturing, a silicon single crystal is manufactured from polycrystalline silicon by known methods like floating zone melting method (or FZ method in short) or Czochralski method (CZ method in short).

The silicon single crystal has the form of an ingot or a block, mostly with a general cylindrical shape.

In order to obtain wafers, the single crystal ingot is sliced into thin wafers having a thickness in the range of 200 µm by a wire saw process.

However, such sawing process produces significant silicon waste which is known as kerf silicon waste.

At present the kerf loss corresponds to about a thickness of 200µm, meaning a loss of about 40% per unit length.

Bearing in mind that the semiconductor industry, in particular the part dedicated to photovoltaic tends to reduce the wafer thickness even more, the kerf losses might become even higher.

As the raw material for manufacturing is already quite expensive, the important kerf losses, which are discarded, become a quite important economic problem.

First attempts have proposed to recycle the kerf waste. But recycling is difficult as kerf waste does not only contain silicon, but also, depending on the saw used and the sawing process, metallic particles, carbon and organic compounds from the liquid containing kerf (coolant or slurry). Such impurities, if not properly eliminated can lead to SI wafers of poor quality or even unusable wafers in particular for photovoltaic applications.

WO2012/109459 relates to a method for recovering silicon value from kerf silicon waste and discusses also other methods to recover kerf waste.

EP2 143 833 relates to a method for manufacturing FZ silicon single crystal by using a silicon crystal material which has dislocation or is polycrystalline and is manufactured by a CZ method. The aim of this document is to manufacture wafers having a larger diameter, in particular of at least 200mm and the raw material for the CZ method is polycrystalline silicon.

The present invention proposes manufacturing method for a silicon single crystal with less kerf losses.

To this extent, the present invention proposes a manufacturing method for a silicon single crystal comprising the steps of:
- providing a silicon raw material containing Si-kerf,
- segregating and shaping the silicon raw material as raw material ingot for a floating zone melting method,
- manufacturing a silicon single crystal by a floating zone melting method in using the raw material ingot.

Thanks to the manufacturing method according to the invention Si-kerf waste can be efficiently recycled and can contribute to cost reduction in Si wafer production.

The manufacturing method for a silicon single crystal according to the invention may comprise one or several of the following features taken alone or in combination :
According to one aspect, the silicon raw material contains x% of Si-kerf and the rest is completed with polycrystalline silicon, where x ≥ 5%, in particular ≥20%, specifically ≥30%, even ≥60% and may be x =100%.

According to another aspect, the Si-kerf results from diamond wire sawing technique applied to a silicon ingot and diamonds particles are previously removed.

In some cases, it seems an advantage that the Si-kerf has been previously purified from carbon residuals.

The Si-kerf may have been previously washed to remove organic residuals.

The segregation and shaping step is carried out by applying a Czochralski method or by applying an EMC method to the silicon raw material for growing an ingot of silicon.

The present invention also relates to a silicon wafer production facility comprising
- a sawing station where silicon single crystal ingots are sawed into wafers and the Si-kerf is collected in order to be used as silicon raw material,
- a station configured to segregate and shape the silicon raw material as raw material ingot for a floating zone melting method,
- a floating zone melting station for manufacturing of a silicon single crystal,
   where said stations form a production loop maintaining the Si-kerf in a closed environment.

According to one aspect, said station configured to segregate and shape the silicon raw material as raw material ingot is a Czochralski silicon melting and crystallization station or an EMC silicon melting and crystallization station to form a silicon raw material ingot.

### BRIEF DESCRIPTIONS OF THE DRAWINGS

Other advantages and characteristics will appear with the reading of the description of the following figures :
- Figure 1 shows an example of a flowchart of manufacturing method of a silicon single crystal and
- Figure 2 shows a scheme of a silicon wafer production facility.

### DETAILED DESCRIPTION

The embodiment(s) in the following description are only to be considered as examples. Although the description refers to one or several embodiments, this does not mean inevitably that every reference concerns the same embodiment, or that the characteristics apply only to a single embodiment. Simple characteristics of various embodiments can be also combined to new embodiments that are not explicitly described.

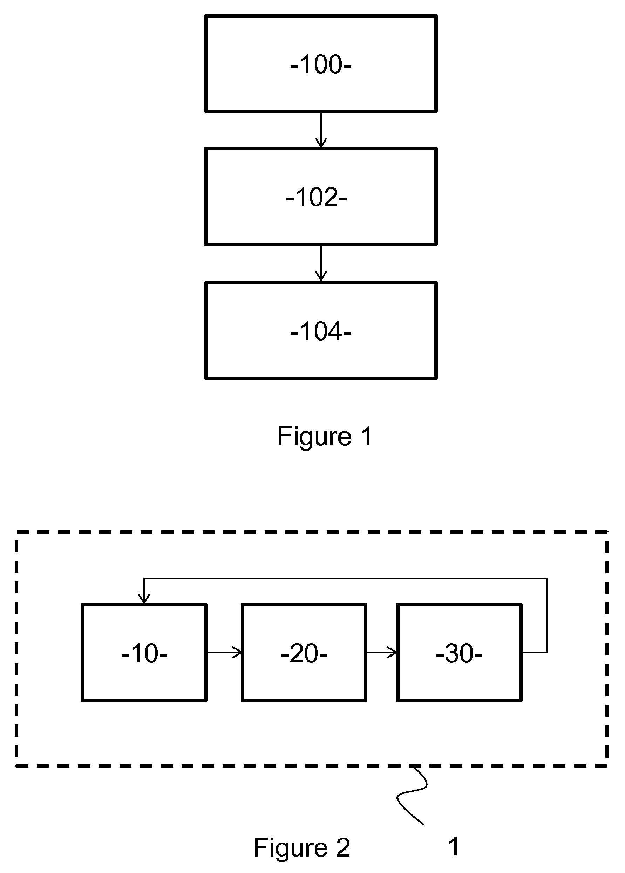

Figure 1 shows an example of a flow chart of a manufacturing method for a silicon single crystal according to the invention.

In a first step 100, a silicon raw material containing Si-kerf is provided.

The Si-kerf results in particular from wafer sawing of Si single crystal ingots for example photovoltaic industry.

As sawing techniques, steel wire sawing or diamond wire sawing can be used.

In case of application of steel wire sawing technique, no previous purification from metallic particles of the Si-kerf is necessary.

In case of diamond wire sawing technique, most diamonds particles are previously removed.

The Si-kerf has also been previously purified from carbon residuals (e.g. SiC particles) if necessary, in particular when the Si-kerf results from steel wire sawing technique.

In function of cutting fluid used for sawing the wafers, the Si-kerf has also been previously washed to remove organic residuals.

The silicon raw material may contain x% of Si-kerf and the rest is completed with polycrystalline silicon, where x ≥ 5%, in particular ≥20%, specifically ≥30%, even ≥60% and may be x =100%. It is clear, that the higher the percentage of Si-kerf, the better the recycling rate.

However, in a Si wafer production facility, one may dispose of several production lines and one may use for example one production line to use all Si-kerf resulting from the other production lines that work on a traditional way.

In a second step 102, the silicon raw material is segregated and shaped to be ready as raw material ingot for a floating zone melting method.

This segregation and shaping step 102 may be carried out in one embodiment by applying a Czochralski method to the silicon raw material for growing an ingot of silicon as disclosed in EP 2 143 833.

According to another embodiment, the segregation and shaping step 102 may be carried out by applying an EMC method (electromagnetic casting method) to the silicon raw material for growing a single crystal ingot of silicon as disclosed for example in US20130247618.

Then in a final step 104, a silicon single crystal is manufactured by a floating zone melting method applied to the raw material ingot that has been realized by CZ method or EMC method.

Figure 2 shows a silicon wafer production facility 1 allowing recycling of Si-kerf.

The silicon wafer production facility 1 comprises different stations 10, 20, 30 that form a unit accomplishing a production cycle for manufacturing silicon wafers.

A first station 10 is a sawing station where silicon single crystal ingots are sawed into wafers and the Si-kerf is collected in order to be used as silicon raw material.

The sawed wafers are stocked and/or taken away in order to be provided later on to semiconductor industry for example for manufacturing of solar panels. The manufacturing process of solar panels may be carried out in the same manufacturing facility as the single silicon crystal facility in order to reduce transportation costs. However, such production facilities are separated in different rooms or halls in order to take into account the specific production conditions, in particular for solar panels.

Then, Si-kerf is provided as at least part of silicon raw material to station 20 configured to segregate and shape the silicon raw material as a raw material ingot for a floating zone melting method.

Station 20 may be a Czochralski or an EMC silicon melting and crystallization station to form a silicon raw material ingot.

The silicon raw material ingot is then handed over to a floating zone melting station 30 for manufacturing of a silicon single crystal.

Once the silicon single crystal is built, it is handed back to sawing station 10 for manufacturing of wafers out of the silicon single crystal by sawing. The different stations 10, 20 and 30 are organized to form a production loop maintaining the Si-kerf in a closed environment and cycle.

The present manufacturing method of a silicon single crystal ingot allows to recycle efficiently Si-kerf waste and thus to reduce the amount of polycrystalline silicone raw material.

Thanks to the segregation and shaping step, the Si - kerf of the raw material can be refined and the use of FZ method allows to get a Si ingot of high purity and good quality in particular for use as wafers for the photovoltaic industry.

The production facility as described above can be built as a loop allowing reduction and efficient recycling of Si-kerf waste and where the Si-kerf is confined and hold in the production loop to end up recycled as silicon in a silicon wafer.

## Claims

1. Manufacturing method for a silicon single crystal comprising the steps of:
- providing (100) a silicon raw material containing Si-kerf,
- segregating and shaping (102) the silicon raw material as raw material ingot for a floating zone melting method,
- manufacturing (104) a silicon single crystal by a floating zone melting method in using the raw material ingot.

2. Manufacturing method as to claim 1, wherein the silicon raw material contains x% of Si-kerf and the rest is completed with polycrystalline silicon, where x ≥ 5%, in particular ≥20%, specifically ≥30%, even ≥60% and may be x =100%.

3. Manufacturing method as to claim 1 or 2, wherein the Si-kerf results from diamond wire sawing technique applied to a silicon ingot and diamonds particles are previously removed.

4. Manufacturing method as to any of claims 1 to 3, wherein the Si-kerf has been previously purified from carbon residuals.

5. Manufacturing method as to any of claims 1 to 4, wherein the Si-kerf has been previously washed to remove organic residuals.

6. Manufacturing method as to any of claims 1 to 5, wherein the segregation and shaping step is carried out by applying a Czochralski method to the silicon raw material for growing an ingot of silicon.

7. Manufacturing method as to any of claims 1 to 6, wherein the segregation and shaping step is carried out by applying an EMC method to the silicon raw material for growing an ingot of silicon.

8. Silicon wafer production facility comprising
- a sawing station (10) where silicon single crystal ingots are sawed into wafers and the Si-kerf is collected in order to be used as silicon raw material,
- a station (20) configured to segregate and shape the silicon raw material as raw material ingot for a floating zone melting method,
- a floating zone melting station (30) for manufacturing of a silicon single crystal,
where said stations (10, 20, 30) form a production loop maintaining the Si-kerf in a closed environment.

9. Silicon wafer production facility as to claim 8, where said station (20) configured to segregate and shape the silicon raw material as raw material ingot is a Czochralski silicon melting and crystallization station to form a silicon raw material ingot.

10. Silicon wafer production facility as to claim 8, where said station (20) configured to segregate and shape the silicon raw material as raw material ingot is an EMC silicon melting and crystallization station to form a silicon raw material ingot.
